# EUROPEAN PATENT APPLICATION

(11) **EP 1 947 640 A2**
(43) Date of publication of application: **23.07.2008**
(21) Application number: 08150412.8
(22) Date of filing: 18.01.2008
(51) Int. Cl.: G10H 3/18, G10H 1/34

(54) **Foot pedal apparatus to provide variable output for electric guitar**

(30) Priority: 18.01.2007 US 655054
(71) Applicant: Electratone, Inc., Scottsdale, Arizona 85262 (US)
(72) Inventor: Francis, Otis M., Phoenix, AZ 85029 (US); Tluczek, Bradley D., Phoenix, AZ 85037 (US)
(74) Representative: McCarthy, Denis Alexis

(57) **Abstract**

A circuit for an electric guitar utilizes a transformer and balanced amplifier to facilitate the production of a variety of sound adjustment circuits.

## Description

This invention relates to musical instruments.

More particularly, the invention relates to apparatus for receiving analog or digital signals that are generated when an instrument is played, and for varying the properties of audio outputs produced from the signals.

Foot pedals are known for controlling the gain, mode, level and tone qualities of sound produced by guitars and other instruments. These foot pedals typically restrict sound qualities to a particular range and limit the sound output qualities that can be produced.

Accordingly, it would be highly desirable to provide an improved foot pedal that increases the range of possible sound outputs.

Therefore, it is a principal object of the instant invention to provide an improved foot pedal for a musical instrument.

A further object of the invention is to provide an improved foot pedal for an electric guitar.

These and other, further and more specific objects and advantages of the invention will be apparent to those of skill in the art from the following detailed description thereof, taken in conjunction with the drawings, in which:
Fig. 1 is a perspective view illustrating a foot pedal constructed in accordance with the invention;
Fig. 2 is a diagram illustrating a portion of the analog circuitry presently preferred in the practice of the invention;
Fig. 3 is a diagram illustrating further analog circuitry presently preferred in the practice of the invention; and,
Fig. 4 is a logic diagram for the foot pedal of Figs. 1 to 3.

Briefly, in accordance with the invention, l provide an improved foot pedal for a guitar. The foot pedal includes an improved circuit to process a signal from an electric guitar. The circuit includes an input to receive the signal from the electric guitar; a first amplifier to receive the signal and produce a first processed signal; a second high gain amplifier to receive the first processed signal and produce a second processed signal; an over-driven transformer to receive the second processed signal and produce a third and fourth processed signals of equivalent magnitude; and, a third balanced amplifier to receive the third and fourth processed signals and produce a fifth processed signal.

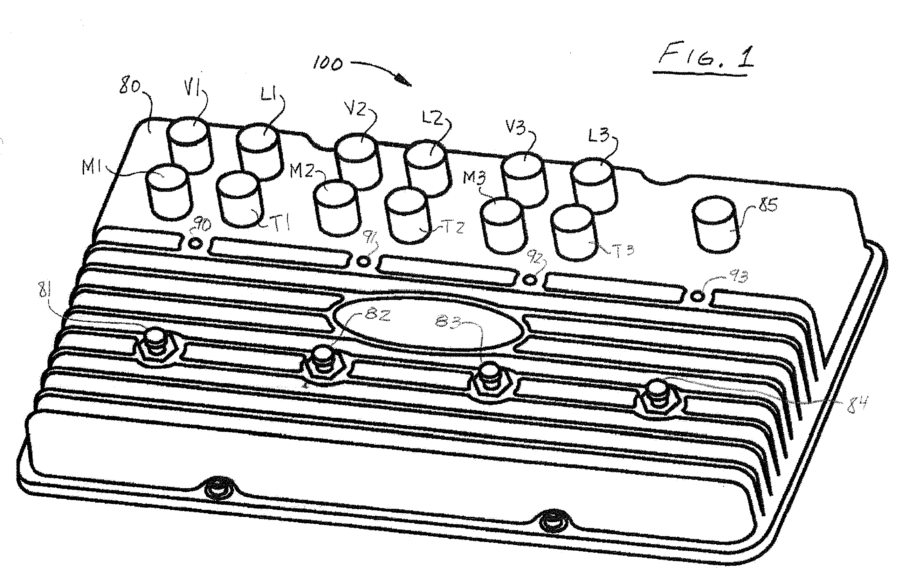

Turning now the drawings, which depict the presently preferred embodiments of the invention for the purpose of illustration thereof, and not by way of limitation of the invention, and in which like characters refer to corresponding elements throughout the several views, Fig. 1 illustrates a foot pedal 100 including foot activated spring loaded buttons 81, 82, 83, 84. Rotatably controlled knobs V1, L1, M1, T1 are operatively associated with button 81. Rotatably controlled knobs V2, L2, M2, T2 are operatively associated with button 82. Rotatably controlled knobs V3, L3, M3, T3 are operatively associated with button 83. Volume control knob 85 is operatively associated with button 84.

Each button 81 to 84 controls a selected channel, which channels will be further described below. When a button 81 to 84 is depressed with the user=s foot (or hand if desired) downwardly from the position illustrated in Fig. 1, and the foot is released or moved away from the button and pedal 100, the button moves upwardly and returns to the position illustrated in Fig. 1. If the channel controlled by a button is off, depressing and releasing the button turns the channel on. Depressing and releasing the button again turns the channel off. In addition, only one of the channels associated with buttons 81 to 83 can be on or selected at any given time. Consequently, if the channel associated with button 81 is on or selected, depressing and releasing button 82 automatically turns off the channel associated with button 81 and selects the channel associated with button 82. Similarly, if the channel associated with button 81 is on or selected, depressing and releasing button 83 automatically turns off the channel associated with button 81 and selects the channel associated with button 83. In contrast, the channel associated with button 84 can be on or selected (or can be off) in combination with any one of the channels associated with buttons 81 to 83.

When button 81 is utilized to select the channel associated with button 81, knob V1 is rotated to control and vary the input gain or volume, knob L1 is rotated to control and vary the output level or volume, knob M1 is rotated to control and vary the mode, and knob T1 is rotated to control and vary the tone.

When button 82 is utilized to select the channel associated with button 82, knob V2 is rotated to control and vary the input gain or volume, knob L2 is rotated to control and vary the output level or volume, knob M2 is rotated to control and vary the mode, and knob T2 is rotated to control and vary the tone.

When button 83 is utilized to select the channel associated with button 83, knob V3 is rotated to control and vary the input gain or volume, knob L3 is rotated to control and vary the output level or volume, knob M3 is rotated to control and vary the mode, and knob T3 is rotated to control and vary the tone.

When button 84 is utilized to select the channel associated with button 84, knob 85 is rotated to control and vary the volume boost that is provided.

The tone knobs T1 to T3 adjust the mix of treble and bass in sound that is produced.

The mode knobs M1 to M3 each adjust a particular mode of music. For example, the mode associated with knob M1 can comprise a Afuzz@ mode that is commonly associated with the 1960's music of the group ROLLING STONES and that is produced utilizing a germanium crystal that clips at 0.3V. In comparison, a silicon crystal typically clips at 0.6V. Another common mode that could, for example, be associated with knob M2 is a mode produced by over driving an amplifier.

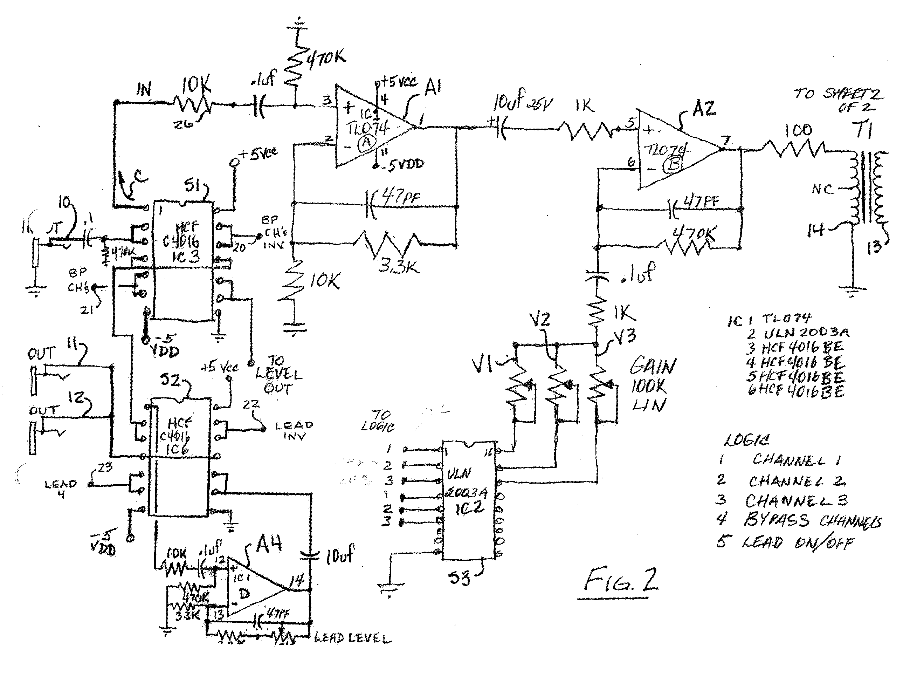

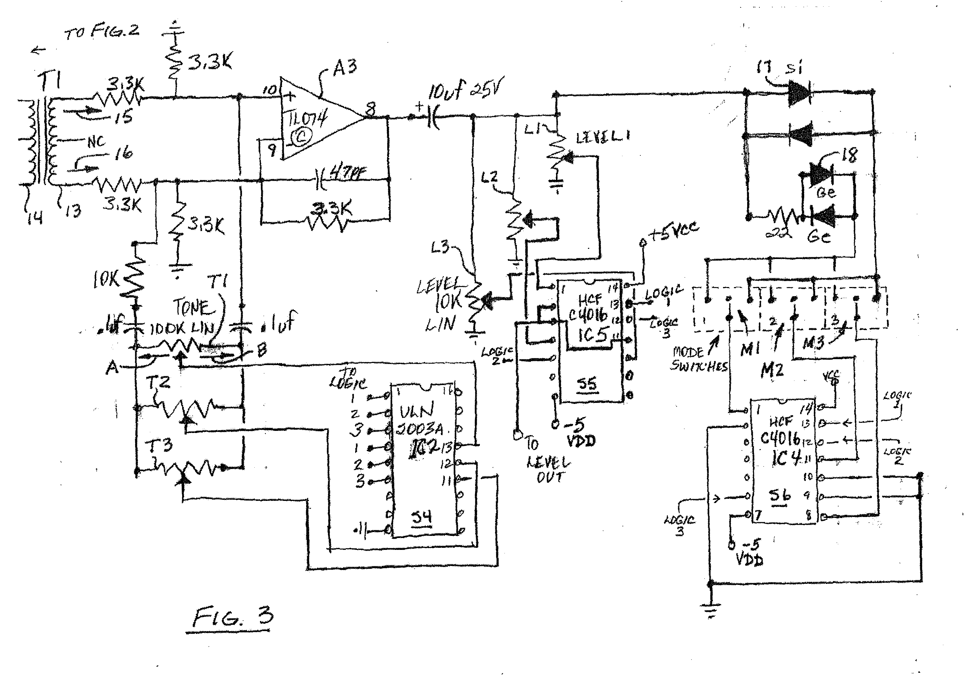

Presently preferred analog circuitry utilized in foot pedal 10 is illustrated in Figs. 2 and 3 The first portion of the circuit, illustrated in Fig. 2, is connected to the second portion of the circuit, illustrated in Fig. 3 by a transformer having a primary coil 14 and a secondary coil 13.

In Fig. 2, the signal from an electric guitar or other instrument is input at 10. If the pedal 10 is in the bypass mode and none of the channels associated with buttons 81 to 83 have been selected, the signal input at 10 goes from switch S1 to switch S2 and through outputs 11 and 12 to the guitar amplifier. If, however, one of the channels associated with buttons 81 to 83 has been selected, the signal passed through switch S1 to amplifier A1. If the channel associated with button 84 has been selected, switch S2 functions to provide volume boost in response to the rotation of knob 85.

Amplifier A1 functions to condition and make uniform the incoming signal. Amplifier A2 is a high gain amplifier The gain from amplifier A2 goes to volume controls V1, V2, V3 corresponding to and adjusted by knobs V1, V2, V3 in Fig. 1. Switch S3 switches each of volume controls V1, V2, V3 on or off. Only one volume control V1, V2, V3 can be on at any given time. A signal from amplifier A2 passed through transformer 13, 14 to balanced recovery amplifier A3 and to tone control switches T1, T2, T3 corresponding to and adjusted by knobs T1, T2, T3 in Fig. 1. Only one tone control T1, T2, T3 can be on at any given time. Switch S4 switches each of tone controls T1, T2, T3 on or off.

A signal from amplifier A3 passes to level control switches L1, L2, L3 corresponding to and adjusted by knobs L1, L2, L3 in Fig. 1, and through diodes to mode control switches M1, M2, M3 corresponding to and adjusted by knobs M1, M2, M3 in Fig. 1. Only one level control switch L1, L2, L3 can be on at any given time. Switch S5 switches each of level controls L1, L2, L3 on or off. Only one mode control switch M1, M2, M3 can be on at any given time.

V1, V2, V3 determine the level of strength of the signal to the transformed to overdrive the transformer to produce tone via switches T1, T2, or T3. The transformer is driven when its magnetic field is saturated. The secondary coil 13 side of the transformer detects the magnetic field produced by the primary coil 14 and produces a signal that is balanced and that includes positive signal 15 and negative signal 16. The strength of signal 15 equals the strength of signal 16.

Mode control switches M1, M2, M3 determine where the signal from the recovery amplifier A3 is clipped. Silicon diodes 17 clip the signal at 0.6 volts. Germanium diodes 18 clip the signal at 0.3 volts. Each knob M1, M2, M3 has three positions. In one position, each knob selects the germanium diodes 18. In a second position, each knob selects the silicon diodes 17. A third position of each knob M1, M2, M3 is a neutral position in which there is no clipping.

Stepping on button 81 to turn its associated channel on activates each control or switch V1, L1, M1, T1 associated with that button. Stepping on button 82 to turn its associated channel on activates each control or switch V2, L2, M2, T2 associated with that button. Stepping on button 83 to turn its associated channel on activates each control or switch V3, L3, M3, T3 associated with that button.

The signal produced by a selected mode control switch M1, M2, M3 goes to output 11, 12 via switches S6, S5, and S2. The signal produced by a selected tone control switch T1, T2, T3 goes to output 11, 12 via switches S4, S3, and S2. The signal produces by a selected level control switch L1, L2, L3 goes to output 11, 12 via switches S5 and S2. Signals travel through output 11, 12 to the guitar amplifier.

If switch S2 is active, a signal goes into the lead boost amplifier A4 (Fig. 2) and this boosts the volume produced by the guitar amplifier. If the channel associated with button 84 is off, then switch S2 is inactive with respect to amplifier A4. The channel associated with button 84 can be on and utilized with one of the channels associated with buttons 81 to 83. Switch S2 is a double pole, double throw switch.

Utilizing transformer 13, 14 to overdrive a coil of wire in the transformer is believed important in the practice of the invention because it mellows and softens the tone of the signal that is produced. Coil 14 creates the magnetic filed. Coil 13 detects the magnetic field. This produces a signal that does not have harsh edges. The transformer is over driven by saturating the magnetic field. The transformer functions as a filter to eliminate noise from the signal from transformer A3. Over driving the transformed is accomplish by directing a high current into the transformer. The transformer is not, of course, manufactured to be over driven, but that is how the transformer is intentionally utilized in the practice of the invention.

The use of a balanced down line amplifier A3 (Fig. 3) with a balanced negative and positive input is also important in the practice of the invention because it functions to reduce noise. Noise is a significant problem in connection with the distortion of sound signals. The circuit is able to utilize a balanced amplifier because of the incorporation of a transformer in the circuit. The circuit of the invention also uses a 10K resistor 26 to reduce loading.

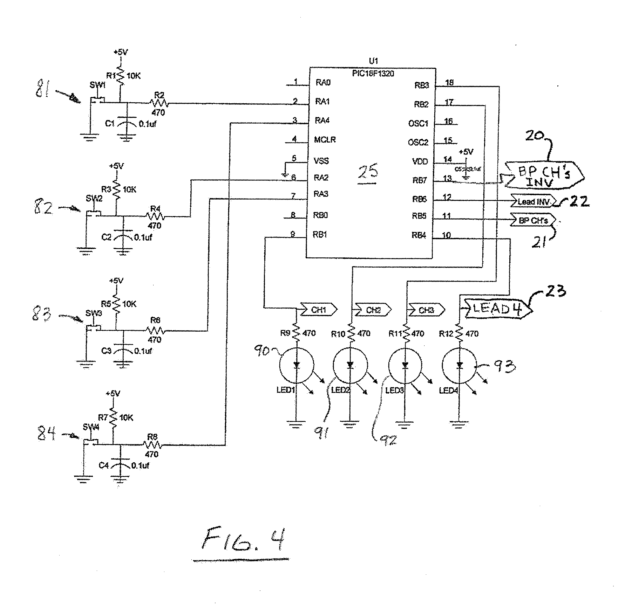

The logic diagram of Fig. 4 includes foot activated buttons 81 to 84, microprocessor 25, LED lights 90 to 93, BP CH=s INV 20, Lead INV 22, BP CH=s 21, and LEAD 4 23.

Having described the presently preferred embodiments and best mode of the invention in such terms as to enable those of skill in the art to understand and practice the invention, l Claim:

## Claims

1. A circuit to process a signal from an electric guitar, including
(a) an input to receive the signal from the electric guitar;
(b) a first amplifier to receive the signal and produce a first processed signal;
(c) a second high gain amplifier to receive said first processed signal and produce a second processed signal;
(d) an over-driven transformer to receive said second processed signal and produce a third and fourth processed signals of equivalent magnitude; and
(e) a third balanced amplifier to receive said third and fourth processed signals and produce a fifth processed signal.
